# EUROPEAN PATENT APPLICATION

(11) **EP 2 145 976 A1**
(43) Date of publication of application: **20.01.2010**
(21) Application number: 09165295.8
(22) Date of filing: 13.07.2009
(51) Int. Cl.: C23C 14/34

(54) **Sputter target assembly having a low-temperature high-strength bond**

(30) Priority: 15.07.2008 US 173557
(71) Applicant: Praxair Technology, Inc., Danbury, CT 06810-5113 (US)
(72) Inventor: Koenigsmann, Holger J., Congers, NY 10920 (US); Lo, Chi-Fung, Fort Lee, NJ 07024 (US); Gilman, Paul S., Suffern, NY 10901 (US)
(74) Representative: Schwan - Schwan - Schorer

(57) **Abstract**

Sputter target assemblies are disclosed, wherein the target and the backing plate are joined together through brazing at low temperatures to produce a superior bond between the target and the backing plate.

## Description

### FIELD OF THE INVENTION

This invention relates generally to the field of sputter targets. In particular, embodiments of this invention relate to improved sputter target assemblies where the target material is joined to the backing plate through brazing at low temperatures so as to form a sputter target assembly useful in the physical vapor deposition of films.

### BACKGROUND OF THE INVENTION

Cathodic sputtering is a widely-used method for depositing thin layers of materials onto substrates. Generally, this process requires a gas ion bombardment of the target having a face formed of a desired material that is to be deposited as a thin film or layer on the substrate. Ion bombardment of the target not only causes atoms or molecules of the target material to be sputtered, but imparts considerable thermal energy to the target. This heat is dissipated by use of a cooling fluid typically circulated beneath or around a backing plate that is positioned in heat exchange relation with the target.

The target forms a part of a cathode assembly that, together with an anode, is placed in an evacuated chamber that contains an inert gas, such as, for example, argon. A high voltage electrical field is applied across the cathode and anode. The inert gas is ionized by collision with the electrons ejected from the cathode. Positively charged gas ions are attracted to the cathode and, upon impingement with the target surface, dislodge target material. The dislodged target materials traverse the evacuated enclosure and deposit as a thin film on the desired substrate that is normally located proximate to the anode.

In conventional target cathode assemblies, the target is attached to a backing plate. The backing plate holds the sputter target in a sputtering chamber and also provides structural support to the sputter target. The backing plate is normally water-cooled to dissipate the heat generated by the ion bombardment of the target. Magnets are typically arranged beneath the backing plate in well-known orientations to form the above-noted magnetic field in the form of a loop or tunnel extending around the exposed face of the target.

To achieve good thermal and electrical contact between the target and the backing plate, these members are commonly attached to each other by soldering, diffusion bonding, clamping, epoxy cements, or with interlocking annular members. The technique selected depends upon the characteristics of the joined materials, as well as the desired properties and characteristics of the target assembly.

The soldering technique is typically used to join a ferromagnetic sputter target, such as, for example, pure nickel (Ni) and Ni-based alloys, such as NiFe and NiFeCo; pure iron (Fe) and Fe-based alloys, such as FeTa, FeCo and FeNi; and pure cobalt (Co) and Co-based alloys, such as CoCr and CoCrPt. According to known techniques familiar to those skilled in the field, the target is typically bonded to the backing plate by means of a solder which may have a melting point of from about 140 to 220°C, such as indium, indium-tin, tin-lead, or tin-silver-copper. However, due to the large difference in thermal expansion properties between the two parts, part warpage and differential part contraction and stresses may occur, causing delamination and other undesirable effects.

For example, U.S. Patent No 5,230,462 to Vascak et al. relates to solder bonding a sputter target to a backing plate for subsequent use in a sputtering operation. The solder is wetted onto the confronting sides of the backing plate and the target, submerging the backing plate and target in a solder bath and subsequently pressing the wetted parts into contact.

In addition, U.S. Patent No. 6,708,870 B2 to Koenigsmann et al. discloses a combination of solid-state bonding and securing a target insert to a backing plate with a filler metal surrounding the perimeter of a cooling or backing plate.

Further, U.S. Patent No. 5,693,203 to Ohhashi et al. discloses the use of solid state bonding to avoid the high pressure and temperatures typically required for diffusion bonding. This patent describes pressing a metal foil between a backing plate and a sputter target to form a solid state bond.

Still further, Gilman et al., in co-pending and commonly assigned U.S. Patent Application 11/480,831, disclose a soldering process for joining a target and backing plate that employs an exothermic film providing sufficient energy to create a solder bond.

In the manufacture of semiconductors, it is common to attach or otherwise secure a sputter target to a backing member, such as, for example, a backing plate to perform sputtering procedures. The backing plate, to which the target is attached, serves as a mount or fixture with which to hold the sputter target during sputtering. It is important to obtain a secure bond between the target and the backing plate, as thermal and mechanical stresses that are generated during the sputtering procedures can cause the target to delaminate or otherwise separate from the backing plate.

Other known methods of diffusion bonding target materials to backing plates can yield less than desirable characteristics in the finished targets. Such known manufacturing processes result in grain growth of target materials, such as aluminum and copper, having a low recrystallization temperature. Furthermore, according to known processes, the mechanical properties of the backing plate materials may deteriorate during diffusion bonding due to the high temperature required.

### SUMMARY OF THE INVENTION

The present invention provides several advantages over the related art. In particular, the present invention provides a brazing powder in combination with applied pressure and an internal heat source to provide a superior bond, in predictable and repeatable fashion, to the target and backing plate. The resulting, desired target assembly properties may be controlled or altered through the placement of a predetermined brazing layer on the face of the target and backing plate to be joined with an ignitable bonding foil therebetween at low temperatures.

In one embodiment, the present invention is directed to a sputter target assembly and processes for manufacturing same. The sputter target assembly includes a brazing layer manufactured from a powder to at least one opposing surface between a target and a backing plate to create a sandwich comprising the target material, an internal heat source (i.e. bonding foil) and a backing plate. The sandwich is placed in a fixture that maintains proper alignment; pressure is applied to the sandwich, and the heat source is ignited. Thereafter, the target assembly is removed from the fixture. Preferably, a material with sufficient heat-generating capability is used, so as to create a bond between the target material and the backing plate, while substantially simultaneously affecting no substantial change to either the microstructure of the target or the mechanical properties of the backing plate.

In another embodiment, the present invention is directed to methods for forming a sputter target assembly comprising the steps of providing a backing plate having an exposed surface, and providing a sputter target having an exposed surface. An amount of brazing material is then provided to the exposed surface of the backing plate, and to the exposed surface of the sputter target, while preferably interposing a bonding foil between the brazing material on the backing plate and the brazing material on the target material. The backing plate and the target material are pressed together under a pre-determined amount of pressure, and a pre-determined amount of current is supplied to the bonding foil (along with a pre-determined amount of pressure) to achieve a required bond between the target material and the backing plate.

According to further embodiments, the present invention is directed to methods for joining target and backing plate materials without substantially changing the microstructure of the target material or the mechanical properties of the backing plate material.

According to still further embodiments, the present invention is directed to methods of joining a target material to a backing plate and obtaining a bond strength significantly exceeding that of a solder bond, such that the resulting sputter target can be used at high power.

Still further, according to present embodiments, processes, apparatuses and systems are disclosed for manufacturing sputter target assemblies having superior adhesion of the backing plate to the sputter target, while requiring advantageously low processing temperatures of less than about 250°C, and preferably from about 20°C to about 150°C.

Further objects, advantages and embodiments of the invention will become evident from the reading of the following detailed description of the invention wherein reference is made to the accompanying drawings.

### BRIEF DESCRIPTION OF THE DRAWINGS

Figure 1 shows an exploded cross-sectional view of an embodiment of the present invention.

Figure 2 shows the embodiment shown in Figure 1 in an assembled state.

Figure 3 shows the embodiment shown in Figures 1 and 2 in a bonded state, now ready to be machined to final dimensions.

Figure 4 depicts the microstructure of a high-purity aluminum-copper alloy target blank prior to bonding.

Figure 5 depicts the microstructure of a high-purity aluminum-copper alloy target blank after bonding.

### DETAILED DESCRIPTION OF THE INVENTION

According to preferred embodiments, the present invention provides a sputter target assembly, wherein the sputter target and the backing plate are bonded by a brazing process. Specifically, the target and the backing plate retain a fine, substantially uniform microstructure during the braze bonding of the assembly. In addition, embodiments of the present invention provide a sputter target assembly that retains the mechanical properties of the backing plate material after the braze bonding. Still further, embodiments of the present invention provide a sputter target assembly where bond separation occurs at a load ranging well in excess of the standard solder bond of about 290 pounds. More preferably, the target assemblies of the present invention comprise bond separation load values of at least 630 pounds. The sputter targets of the present embodiments can therefore be useful at a higher sputter power than known targets, such as, for example, those produced using solder.

The invention provides a novel, cost effective bond for the sputter target assembly that meets customer requirements for a fine, substantially uniform microstructure of the target material, a strong backing plate, and a high bond strength.

In accordance with an exemplary embodiment of the present invention, a brazing material, (such as, for example, a brazing powder), is preferably placed on the joining surface of the backing plate and target material by thermally spraying. The preparatory steps prior to the application of the brazing powder are known to those skilled in the field of sputter target manufacture.

Upon completion of the preparatory steps, a coating of brazing powder can be deposited on both the target and backing plate using, conventional methods and known compositions. For example, High-Velocity Oxy-Fuel (HVOF) thermal spray process can be utilized to apply a coating having a composition of 60Ag-30Cu-10Sn weight percent (wt.%). In this process, a blend of fuel and oxygen is brought together to burn. The gas flow expands due to the shape of the nozzle and reaches a high velocity. The brazing powder is then injected in the gas flow, creating a controllable beam of hot gas and particles. When the beam hits the target or backing plate, the brazing powder forms a coating. The resulting coating has a porosity of less than about 5%, a density of at least about 95% of the theoretic density, and an average coating thickness of from about 0.004 to about 0.012 inches with a preferred thickness range of about 0.0005 inches per inch diameter. For instance, in a target having a four inch diameter, the thickness range would be 0.002 inches, whereas for a target having a ten inch diameter, the thickness range would be 0.005 inches.

A bonding foil such as an ignitable heterogeneous stratified structure is oriented in the center of the target assembly. Such a bonding foil is disclosed in copending and commonly assigned US Patent Application Number 11/480,831, to Gilman et al., the entire contents of which are incorporated by reference herein as if made a part of the present specification. The bonding foil is in essence surrounded by the target brazing powder layer and the backing layer brazing powder layer. The brazing powder is preferably ignited via a DC source (not shown), so that an exothermic reaction is propagated. The heat generated during this reaction melts the brazing layer, but does not penetrate into sputter target or backing plate. Preferably, the depth of heat penetration is about 0.012 inches or less, causing the applied brazing layer to melt and bond together substantially contemporaneously without causing warping or disturbance in the crystallographic or metallurgical structure of either sputter target or backing plate. As a result the sputter target maintains its flatness as well as its metallurgical integrity.

In another exemplary embodiment of the invention, the components to be bonded can be placed in a press capable of delivering a load of at least about 50,000 pounds, such as, for example hydraulic, screw, manual or computer operated, etc. Alignment fixtures contain precision spacers which are placed on alignment pins, so as to center and align backing plate and sputter target. The braze layers are applied onto the backing plate and the sputter target, respectively, to a thickness ranging from about 0.004 to 0.012 inches. An aluminum spacer plate such as aluminum alloy 6061 is placed on a neoprene sheet material to distribute the load uniformly over the backing plate. A load of at least about 50,000 pounds is applied in bringing the components together. Direct current electrical connections can be attached to the press. In particular, the negative lead from a DC source (not shown) can be attached to the backing plate and the positive lead is connected to the bonding foil. Upon stabilization of the pressure applied via platens, the bonding foil is ignited, causing an exothermic reaction as discussed above. The bonding/brazing layer melts and becomes a layer having a depth of about 0.015 inches thus forming a sputter target assembly by attaching a sputter target to a backing plate. Subsequent to bonding, the integrated target assembly is removed from the press. The pressure loads contemplated as useful in embodiments of the present invention range from about 50,000 to about 120,000 pounds depending on the target dimension. For example, it was determined that an appropriate load of about 107,000 pounds should be applied to a target having a diameter of 17.700 inches, corresponding to a pressure of about 435 psi.

The bonded and machined sputter target assembly can be ultrasonically inspected to determine if there are any defects in the bond. Ultrasonic and mechanical measurements can be made to confirm the dimensions of the finished target assembly configuration.

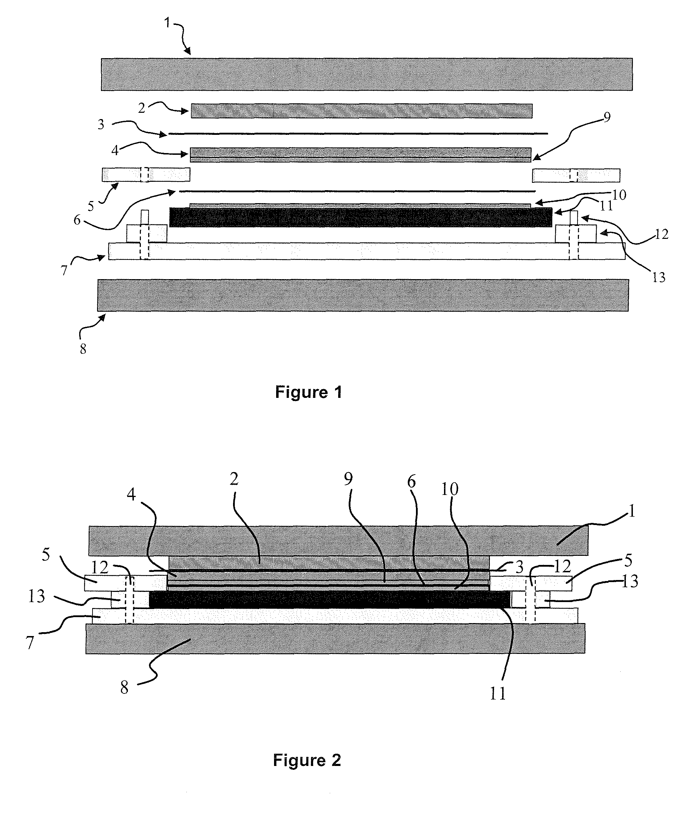

More specifically, and with reference to Figure 1 in an exemplary embodiment the target and backing plate components to be bonded are placed in a press to obtain consistent pressure on the assembly. The assembly consists of an alignment fixture (7) with precision spacers (5, 13) placed on precision alignment pins (12) to align the backing plate (11), such as an aluminum alloy 6061. Pressure is applied, and a substantially uniform layer of brazing powder (10), such as the commercially available Cusiltin-10 manufactured by Wesgo Metals Products (Hayward, California) having a composition of 60Ag-30Cu-10Sn (wt.%) is applied to the backing plate and the target surfaces which are to be joined. The brazing powder has a thickness ranging from about 0.004 to about 0.012 inches, and with the bonding foil (6) placed therebetween having a thickness ranging from about 0.002 to about 0 .008 inches. The sputter target material (4) in this exemplary embodiment is preferably a high-purity aluminum-copper alloy with a substantially uniform layer of brazing powder (9) applied thereto at temperatures below 250°C, and preferably from about 20°C to about 250°C. In this exemplary embodiment the braze material was Cusiltin-10 having a composition of 60Ag-30Cu-10Sn (wt.%) applied to a thickness of from about 0.004 to about 0.012 inches. A neoprene sheet (3) of about the same diameter as the sputter target material, typically 17.700 inch diameter is placed thereon to compensate for any deformities in the sputter target material surface. An aluminum spacer plate (2), typically aluminum alloy 6061, of the same diameter as the sputter target material is placed on the neoprene sheet (3) to distribute the load of about 107,000 pounds evenly over the assembly to be bonded.

As shown in Figure 2, the assembled components in the alignment fixture are placed in a press, such as, for example, a hydraulic, screw or manual press, with a capacity of about 107,000 pounds. Direct current (DC) electrical connections are attached to the assembly; the negative lead attached to the alignment fixture (7) and the positive lead connected to the bonding foil (6). Pressure is applied to the assembly. When the pressure stabilizes, the bond foil (6) is ignited with a DC source (not shown) causing an exothermic reaction which penetrates the applied braze layers (9, 10) to a depth of about 0.012 inches or less causing the applied brazing powder to melt and bond together instantaneously without causing a microstructural disturbance in either the target or backing plate materials.

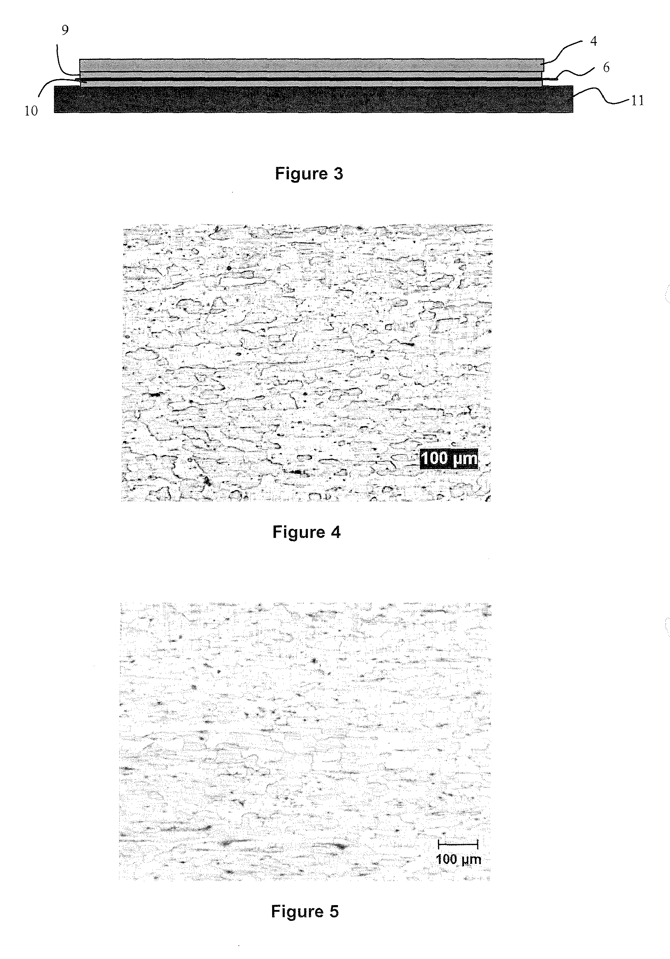

After ignition of the bonding foil and subsequent bonding of the assembly the pressure is released and the bonded assembly (20) is removed from the alignment fixture, as shown in Figure 3. While this exemplary embodiment illustrates bonding a high-purity aluminum-copper alloy to aluminum alloy 6061 using Cusiltin-10 having a composition of 60Ag-30Cu-10Sn (wt.%) as a brazing powder, it is noteworthy that this invention can be used with similar effectiveness on sputter targets and backing plate materials of any diameter, shape or configuration, alloy or composition which may be suitable for use as a sputter target assembly, such as, for example, aluminum, titanium, copper, and tantalum or alloys thereof using any kind of brazing powder, such as Incusil-ABA having a composition of 59Ag-27.3Cu-12.5In-1.2Ti (wt.%), or Incusil-15 having a composition of 61.5Ag-23.5Cu-15In (wt.%). The brazing powder can be a composition including from about 57 to 63 percent silver, from about 22 to about 32 percent copper, from about 0 to about 12 percent tin, from about 0 to about 17 percent indium, and from about 0 to about 3 percent titanium by weight, wherein no more than two of these constituent component can be zero weight percent.

The target assembly of the present invention will be further described in detail with reference to the following examples, which are, however, not to be construed as limiting the invention.

### COMPARATIVE EXAMPLE

As a comparative example to the target assembly of the present invention, a solder bonded target assembly was prepared as follows: A high-purity aluminum-copper target blank and an aluminum alloy 6061 backing plate blank were electroplated with 0.0005 inches of nickel. Both blanks were then placed on a hot plate having a temperature of 220°C. After applying flux to the bonding surfaces, molten solder comprising tin in an amount of 63 weight percent and lead in an amount of 37 weight percent was applied to the fluxed bonding surfaces. The surface oxide was removed from the bonding surfaces and the two blanks were then joined together. Subsequently the assembly was air cooled to room temperature while a pressure of 300 psi was applied.

### RESULTS

The solder bonded target assembly of the Comparative Example was subsequently ultrasonically inspected for bond coverage and compared with the one prepared in accordance to the present invention, where the braze material selected was Cusiltin-10 having a composition of 60Ag-30Cu-10Sn (wt.%). Both assemblies showed a bond coverage of more than 99 percent. Additionally, the bond strength was evaluated through tensile testing. Bond separation of the assembly of the target assembly prepared according to the present invention occurred at a load of 630 pounds, whereas bond separation of the standard solder bonded assembly occurred at a load of 290 pounds. Further, as shown in the micrographs of Figs. 4-5, the microstructure of the target assembly bonded in accordance to the present invention did not change. The average grain size of the high-purity aluminum-copper blank prior to bonding was 42 microns as shown in Figure 4, and the average grain size of the high-purity aluminum copper blank after bonding was 42 microns as shown in Figure 5.

While the present invention has been described in detail with reference to specific embodiments thereof, it will be apparent to one skilled in the field that various changes, modifications, and substitutions can be made, and equivalents employed without departing from, and are intended to be included within, the scope of the claims.

## Claims

1. A sputter target assembly employed in a physical vapor deposition chamber, comprising:
a backing plate having an exposed surface;
a sputter target having an exposed surface;
a brazing material layer applied at low temperatures to the exposed surface of the backing plate, and to the exposed surface of the sputter target;
an ignitable bonding foil layer, wherein the ignitable bonding foil is a heterogeneous stratified structure interposed between the brazing material on the backing plate and the brazing material on the target material, said backing plate and sputter target are united to form a target assembly comprising bond separation load value in excess of 600 pounds, wherein the microstructure of the target and the backing plate is substantially unchanged post assembly, and said target assembly is operable at a power exceeding 20 kW in the chamber.

2. The sputter target assembly of Claim 1, wherein the brazing material comprises a brazing powder comprising from about 57 to 63 percent silver, from about 22 to about 32 percent copper, from about 0 to about 12 percent tin, from about 0 to about 17 percent indium, and from about 0 to about 3 percent titanium by weight, wherein no more than two of these constituent components can be zero weight percent.

3. The sputter target assembly of Claim 1, wherein the brazing material comprises a brazing powder comprising about 60 percent silver, about 30 percent copper and about 10 percent tin by weight.

4. The sputter target assembly of Claim 1, wherein the thickness of the bonding foil is from about 0.002 to about 0.008 inches.

5. The sputter target assembly of Claim 1, wherein the brazing material is provided in a substantially uniform layer.

6. The sputter target assembly of Claim 1, wherein the brazing material has a thickness of from about 0.004 to about 0.012 inches.

7. The sputter target assembly of Claim 1 wherein the pressure is applied via a press selected from the group consisting of: a screw press, a hydraulic press and a manual press.

8. The sputter target assembly of Claim 1, wherein the backing plate is made from a material selected from the group consisting of aluminum, aluminum alloys, copper, copper alloys, titanium, titanium alloys, and mixtures thereof.

9. The sputter target assembly of Claim 1, wherein the backing plate is made from a material selected from the group consisting of aluminum alloys, copper, and copper alloys.

10. The sputter target assembly of Claim 1, wherein the sputter target is made from a material selected from the group consisting of high-purity aluminum and aluminum alloys, high-purity copper and copper alloys, high-purity titanium, and high-purity tungsten.

11. The sputter target assembly of Claim 1 wherein the brazing is applied via a thermal spray process.

12. A sputter target assembly comprising:
a backing plate;
a sputter target;
a bond layer interposed between the backing plate and the sputter target, said bond layer having a powdered brazing material layer disposed on the sides in contact with the sputter target and backing plate, respectively, forming a sputter target assembly, comprising bond separation load value in excess of 600 pounds, and wherein the microstructure of the sputter target and backing plate is unchanged post assembly.

13. A semiconductor manufacturing system comprising the sputter target assembly of Claim 12.

14. A semiconductor component manufactured in a semiconductor manufacturing process comprising the sputter target assembly of Claim 13.

15. A method of forming a sputter target assembly employed in a physical vapor deposition chamber, comprising the steps of:
providing a backing plate having an exposed surface;
providing a sputter target having an exposed surface;
applying a braze material layer by thermal spray at low temperatures to the exposed surface of the backing plate and to the exposed surface of the sputter target;
interposing an ignitable bonding foil, wherein the ignitable bonding foil is a heterogeneous stratified structure, between the brazing material layer on the backing plate and the brazing material layer on the sputter target;
pressing the backing plate and the sputter target under a predetermined pressure;
supplying a predetermined amount of current to the bonding foil with a predetermined amount of pressure to obtain a sputter target assembly comprising bond separation load value in excess of 600 pounds, and wherein the microstructure of the sputter target and backing plate is substantially unchanged post assembly.

16. The method of claim 15, further comprising the steps of:
aligning the sputter target and the backing plate prior to pressing; and
applying a load of from about 50,000 to about 120,000 pounds.

17. The method of claim 15, wherein the current applied to ignite the foil is from about 5 volts to about 50 volts.
